# EUROPEAN PATENT APPLICATION

(11) **EP 4 567 446 A1**
(43) Date of publication of application: **11.06.2025**
(21) Application number: 24176007.3
(22) Date of filing: 15.05.2024
(51) Int. Cl.: G01R 31/389, G01R 31/396, G01R 31/36

(54) **METHOD FOR CELL INSPECTION, ENERGY STORAGE SYSTEM AND ENERGY STORAGE STATION**

(30) Priority: 04.12.2023 CN 202311678518
(71) Applicant: Sungrow Power Supply Co., Ltd., Hefei, Anhui 230088 (CN)
(72) Inventor: GENG, Houlai, Hefei, 230088 (CN); PAN, Tao, Hefei, 230088 (CN); LI, Panpan, Hefei, 230088 (CN); LI, Qing, Hefei, 230088 (CN); DONG, Puyun, Hefei, 230088 (CN)
(74) Representative: Epping - Hermann - Fischer

(57) **Abstract**

An energy storage system, a method for cell inspection by the energy storage system, and an energy storage station are provided. The energy storage system includes a PCS and at least one battery cluster. The battery cluster includes multiple cells. The method includes: sending an inspection command to instruct the PCS to regulate power, upon receipt of a cell inspection command; determining a current signal of the battery cluster; and for each of the plurality of cells, determining a voltage signal of the cell, calculating an impedance of the cell based on the current signal and the voltage signal, and determining based on the impedance whether the cell malfunctions. Therefore, aging of the cells can be known to protect other cells from being affected by a malfunctioning cell, thereby improving reliability. Further, all the cells can be inspected simultaneously, and therefore any malfunctioning cell can be rapidly detected.

## Description

### FIELD

The present disclosure relates to the technical field of energy storage, and in particular to an energy storage system, a method for cell inspection by the energy storage system, and an energy storage station.

### BACKGROUND

Electrochemical cells have advantages of high energy density, high output voltage and long cycle life and are environmentally friendly, and therefore are widely used in various electronic devices, electric vehicles and electrochemical systems. Usage of electrochemical systems in China, which has been predicted to be exceeded 2000MW by 2020, is increasing, at a compound annual growth rate approximating 70%.

The energy storage system generally includes multiple electrochemical cells that are inevitably worn-out or malfunction as the energy storage system operates. The worn-out or malfunctioning cell decreases in battery capacity, resulting in poor performance of the energy storage system and even fire hazards. Therefore, it is necessary to pay attention to aging of each cell.

In view of this, how to detect a malfunctioning cell to prevent resulting damages to other cells is a technical problem to be solved urgently.

### SUMMARY

In view of the above, an energy storage system, a method for cell inspection by the energy storage system, and an energy storage station are provided according to the present disclosure. Technical solutions are as follows.

The energy storage system includes a logical controller, a power conversion system and at least one battery cluster. The battery cluster includes multiple cells. A direct current side of the PCS is electrically connected to the battery cluster. A cluster management unit (CMU) and multiple battery management units (BMU) are arranged in the battery cluster. The BMU is electrically connected to at least one of the multiple cells. The CMU is communicatively connected to the multiple BMUs. The logical controller, the PCS, the BMU and the CMU are configured to cooperate. The logical controller is configured to send an inspection command upon receipt of a cell inspection command. The PCS is configured to regulate power. The BMUs are each configured to acquire a current signal of the battery cluster and a voltage signal of the cell connected to the BMU, calculate an impedance of the cell based on the current signal and the voltage signal, and transmit the impedance to the logical controller. The logical controller is configured to determine based on the impedance whether the cell malfunctions.

The method for cell inspection by the energy storage system includes: sending an inspection command to instruct the PCS to regulate power, upon receipt of a cell inspection command; determining a current signal of the battery cluster; and for each of the plurality of cells, determining a voltage signal of the cell, calculating an impedance of the cell based on the current signal and the voltage signal, and determining based on the impedance whether the cell malfunctions.

The energy storage station includes an energy management system EMS and the energy storage system that is numbered at least one. The EMS is configured to send a cell inspection command to the logical controller, for the energy storage system to perform cell inspection.

Compared to the conventional technology, the present disclosure can achieve the following beneficial effects.

An energy storage system, a method for cell inspection by the energy storage system, and an energy storage station are provided according to the present disclosure. The energy storage system includes a power conversion system and at least one battery cluster. The battery cluster includes multiple cells. The method includes: sending an inspection command to instruct the PCS to regulate power, upon receipt of a cell inspection command; determining a current signal of the battery cluster; and for each of the plurality of cells, determining a voltage signal of the cell, calculating an impedance of the cell based on the current signal and the voltage signal, and determining based on the impedance whether the cell malfunctions. In this way, aging of the cells can be known to protect other cells from being affected by a malfunctioning cell, thereby improving reliability of cells. In addition, all the cells in the energy storage system can be inspected simultaneously with this method, and therefore any malfunctioning cell can be rapidly detected.

### BRIEF DESCRIPTION OF THE DRAWINGS

For more clearly illustrating embodiments of the present disclosure or technical solutions in the conventional technology, the drawings for illustrating the embodiments or the conventional technology will be briefly described hereinafter. Apparently, the drawings in the following description are only some examples of the present disclosure, and for those skilled in the art, other drawings may be obtained based on the provided drawings without any creative efforts.
Figure 1 is an equivalent circuit diagram of an energy storage system in which multiple converters are connected in parallel according to the conventional technology;
Figure 2 is an equivalent circuit diagram of a single energy storage system according to the conventional technology;
Figure 3 is a schematic flowchart illustrating a method for cell inspection by the energy storage system according to an embodiment of the present disclosure;
Figure 4 is a schematic flowchart partially illustrating the method for cell inspection by the energy storage system according to an embodiment of the present disclosure; and
Figure 5 is a schematic structural diagram of an energy storage station according to an embodiment of the present disclosure.

### DETAILED DESCRIPTION

Technical solutions of embodiments according to the present disclosure are clearly and completely described hereinafter in conjunction with the drawings of the embodiments of the present disclosure. Apparently, the embodiments described below are only some rather than all of the embodiments of the present disclosure. Based on the embodiments described herein, all of the other embodiments obtained by those skilled in the art without any creative work fall within the protection scope of the present disclosure.

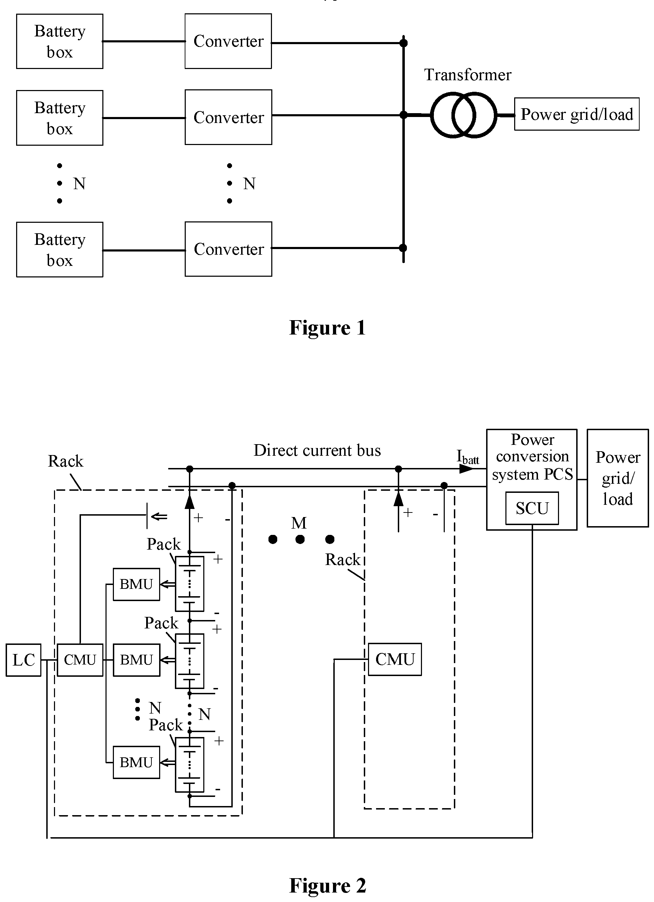

Figure 1 is an equivalent circuit diagram of an energy storage system in which multiple converters are connected in parallel according to the conventional technology. In general, N battery boxes are connected in series to N converters respectively whose alternating current sides are connected in parallel and then are connected to an isolation transformer, and finally supply power to a power grid or load.

Figure 2 is an equivalent circuit diagram of a single energy storage system according to the conventional technology. In general, the battery box includes M battery clusters RACK connected in parallel. Each RACK includes N battery packs PACK connected in series. Each PACK includes multiple cells connected in series. M is greater than or equal to 1, and N is greater than or equal to 1. Each RACK includes at least one BUM (battery management unit) for oversight. The BUM is configured to acquire information about a cell corresponding to the BUM in the RACK. The information about the cell includes but is not limited to cell voltage, cell temperature, etc. Each RACK is provided with at least one CMU (cluster management unit). The CMU is configured to acquire information form the BMU and send a command to the BMU. In addition, the CMU also is configured to measure information about the RACK, including but not limited to, RACK current and RACK voltage.

The battery box is further provided with at least one LC (logical controller), which is configured to acquire information from the CMU and send a command to the CMU. The LC is further communicatively connected to a PCS (power conversion system). For example, the LC is communicatively connected to a SCU (smart communication unit) in the PCS, to acquire information from the SCU and send a command to the SCU. Both terminals of the RACK are connected to the direct current side of the power conversion system through a direct current bus, for supplying current I_{batt} to the power conversion system. The alternating side of the power conversion system is connected to the power grid or load.

As mentioned in the BACKGROUND section, cells are inevitably worn-out or malfunction as the energy storage system operates. In order to protect other cells from being affected by a malfunctioning cell, inspection is performed on each cell at present, for example, by measuring internal resistance of the cell.

However, there are a large number of cells in the battery box at present. For example, the number M of RACK is 10, the number N of PACK is 6, and the number of cells in each PACK is 64, and then the number of all cells in the RACK is up to 3840, increasing difficulties in inspecting all the cells. Further, cells in an energy storage system are too numerous to be inspected.

In view of this, a method for cell inspection by the energy storage system is provided according to the present disclosure. The energy storage system includes a power conversion system PCS and at least one battery cluster RACK. The RACK includes multiple cells. The method is detailed as follows. An inspection command is sent to the PCS upon receipt of a cell inspection command, for the PCS to regulate power. Therefore, current flowing through the cell and voltage across the cell are varying. Then, a current signal of the RACK and a voltage signal of the cell are determined, and impedance of the cell is calculated based on the current signal and the voltage signal. It is determined based on the impedance whether the cell malfunctions. In this way, aging of the cells can be known to protect other cells from being affected by a malfunctioning cell, thereby improving reliability of cells. In addition, all the cells in the energy storage system can be inspected simultaneously with this method, and therefore any malfunctioning cell can be rapidly detected.

The present disclosure is illustrated in detail in conjunction with the drawings and specific embodiments hereinafter, so that the above purposes, features and advantages of the present disclosure are understandable.

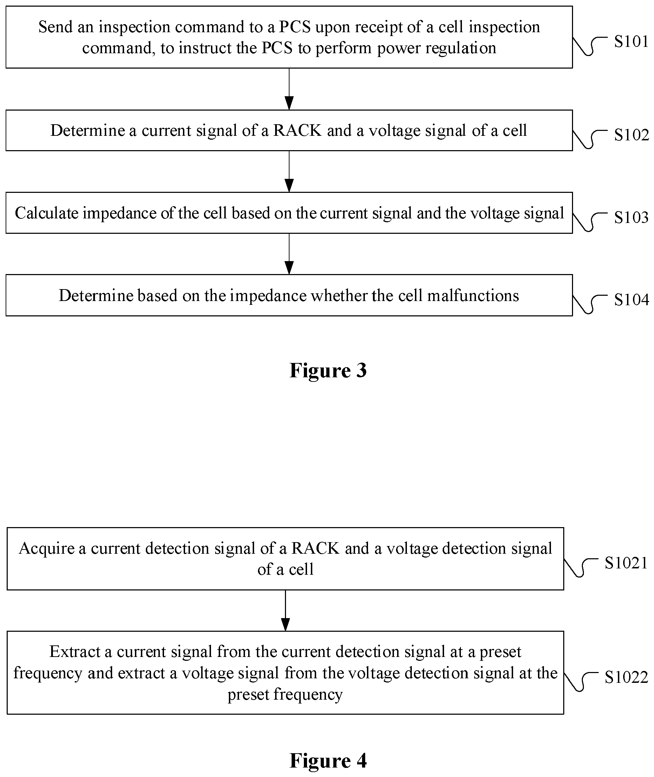

Figure 3 is a schematic flowchart illustrating the method for cell inspection by the energy storage system according to an embodiment of the present disclosure. The energy storage system includes a power conversion system PCS and at least one battery cluster RACK. The RACK includes multiple cells. The method includes the following steps S101 to S104.

In step S101, an inspection command is sent to instruct the PCS to regulate power, upon receipt of a cell inspection command.

In this step, the cell inspection command is sent to the energy storage system for subsequent cell inspection. The cell inspection command may be sent regularly or in real time, which is not limited herein. The energy storage system switches to a cell inspection mode and sends the inspection command to the PCS upon receipt of the cell inspection command, for the PCS to regulate power.

In an embodiment, sending the inspection command to instruct the PCS to regulate power includes: sending the inspection command; and generating an alternating-current voltage signal at a preset frequency by the PCS and inputting the alternating-current voltage signal into the RACK.

In an embodiment, the preset frequency ranges from 0Hz to 1kHz.

The PCS generates the alternating-current voltage signal at the preset frequency based on the received inspection command. The preset frequency ranges from 0Hz to 1kHz. For example, the PCS generates the alternating current voltage signal at a frequency of 5Hz, 200Hz, or 600Hz. However, the preset frequency ranges from, but not limited to, 0Hz to 1kHz, which is only a preferable solution. In other embodiments, the preset frequency is set as needed, for example, from 0Hz to 10kHz. In addition, the PCS generates the alternating-current voltage signal at the frequency that continuously varies from 0Hz to 10kHz, for inspecting the cell throughout the frequency range. For example, the PCS generates the alternating-current voltage signal at the frequency of 1Hz first, ..., and finally generates the alternating-current voltage signal at the frequency of 1kHz. Then, the PCS inputs the alternating-current voltage signal at the preset frequency into the RACK through the direct current bus. In other embodiments, the PCS generates the alternating-current voltage signal at the frequency that varies discontinuously. For example, the PCS generates the alternating-current voltage signal at the frequency of 1Hz first, then 20 Hz, and then 5Hz.

In an embodiment, generating the alternating-current voltage signal at the preset frequency by the PCS and inputting the alternating-current voltage signal into the battery cluster includes: generating the alternating-current voltage signal at the preset frequency by a direct current to direct current (DC/DC) conversion circuit in the PCS; and inputting the alternating-current voltage signal into the battery cluster connected to the DC/DC conversion circuit.

In this embodiment, the DC/DC conversion circuit is provided in the PCS and is connected to the RACK. An alternating current quantity at the preset frequency is set. The DC/DC conversion circuit generates the alternating-current voltage signal at the preset frequency based on the alternating current quantity, and inputs the alternating-current voltage signal at the preset frequency into the RACK connected to the DC/DC conversion circuit. It should be noted that there is no specific limitation on how to input the alternating-current voltage signal at the preset frequency into the RACK.

In step S 102, the current signal of the RACK and the voltage signal of the cell are determined.

Figure 4 is a schematic flowchart partially illustrating the method for cell inspection by the energy storage system according to an embodiment of the present disclosure. In an embodiment, the determination of the current signal of the RACK and the voltage signal of the cell includes the following steps S 1021 to S1022.

In step S 1021, a current detection signal of the RACK and a voltage detection signal of the cell are acquired.

The cells in the RACK are connected in series, and therefore share the same current. The current detection signal of the RACK is the same as the current detection signal of the cell. Further, a voltage detection signal of the cell is acquired.

In step S 1022, the current signal is extracted from the current detection signal at the preset frequency, and the voltage signal is extracted from the voltage detection signal at the preset frequency.

In an embodiment, extracting the current signal from the current detection signal at the preset frequency and extracting the voltage signal from the voltage detection signal at the preset frequency includes: performing Fast Fourier Transform on the current detection signal and the voltage detection signal at the preset frequency.

For each of the cells, the current detection signal and voltage detection signal of each cell are acquired. Then, the fast Fourier transform is performed on the current detection signal and the voltage detection signal, to obtain the voltage signal and the current signal at the preset frequency to be inputted into the cell. Since the preset frequency varies continuously, the current detection signal and the voltage detection signal at varying preset frequency can be obtained. The inputted signal has the same frequency as the extracted signal. For example, the inputted signal has frequency of 5Hz, and then the fast Fourier transform is performed on the acquired current detection signal and the acquired voltage detection signal to obtain the current signal of the RACK and the voltage signal of the cell at the frequency of 5Hz. Alternatively, the inputted signal has frequency of 260Hz, and then the fast Fourier transform is performed on the acquired current detection signal and the acquired voltage detection signal to obtain the current signal of the RACK and the voltage signal of the cell at the frequency of 260Hz. It should be noted that the extraction on the current detection signal and the voltage detection signal is not limited to the fast Fourier transform. In other embodiment, the extraction is performed through frequency selection, for example, by a band-pass filter.

In step S103, impedance of the cell is calculated based on the current signal and voltage signal.

In this step, for each of the cells, the impedance of the cell is calculated based on the current signal and voltage signal. In addition, the impedance of the cell is calculated based on the varying frequency. Further, the impedance over the varying frequency is drawn to inspect the cell in advance if necessary.

In step 104, it is determined based on the impedance whether the cell malfunctions.

In an embodiment, the determining based on the impedance whether the cell malfunctions includes: determining whether a difference between the impedance and preset internal resistance of the cell is less than a preset difference, or determining whether the impedance is within a preset reference range; determining that the cell does not malfunction if determined that the difference is less than the preset difference or if determined that the impedance is within the preset reference range; and determining that the cell malfunctions if determined that the difference is not less than the preset difference of if determined that the impedance is not within the preset reference range.

In step S103, for each of the cells, the impedance of the cell at the preset frequency is calculated. The difference between the impedance and corresponding preset internal resistance of the cell is calculated, and is compared with the preset difference. It should be noted that the preset internal resistance difference is calculated after a number of charge and discharge cycles, or is measured throughout the aging of the cell. A result that the difference between the impedance and the preset internal resistance of the cell is less than the preset difference indicates that the cell does not malfunction. Otherwise, a result that the difference between the impedance and the preset internal resistance of the cell exceeds the preset difference indicates that the cell malfunctions.

Alternatively, it is determined whether the impedance of the cell is within the preset reference range, which is specific to the cell. A result that the impedance of the cell is within the preset reference range indicates that the cell does not malfunction. Otherwise, a result that the impedance of the cell is not within the preset reference range indicates that the cell malfunctions. This facilitates early warning by the energy storage system.

The energy storage system sends the inspection command to the PCS upon receipt of the cell inspection command, for the PCS to regulate power. Therefore, the current flowing through the cell and the voltage across the cell are varying. Then, the current signal of the RACK and the voltage signal of the cell are determined, and impedance of the cell is calculated based on the current signal and the voltage signal. It is determined based on the impedance whether the cell malfunctions. In this way, aging of the cells can be known to protect other cells from being affected by a malfunctioning cell, thereby improving reliability of cells. In addition, all the cells in the energy storage system can be inspected simultaneously with this method, and therefore any malfunctioning cell can be rapidly detected.

Base on the above method for cell inspection, an energy storage system is further provided according to the present disclosure. The above method is applied to the energy storage system. The energy storage system includes a logical controller LC, a power conversion system PCS and at least one battery cluster RACK. The RACK includes multiple cells. A direct current side of the PCS is electrically connected to the RACK. A cluster management unit CMU and multiple battery management units BMU are arranged in the RACK. Each BMU is electrically connected to at least one of the cells. The CMU is communicatively connected to the multiple BMUs. The LC is communicatively connected to the CMU and the PCS. The LC, the PCS, the BMU and the CMU cooperate to perform the method for cell inspection as detailed above.

The LC is configured to send an inspection command upon receipt of a cell inspection command. The PCS is configured to regulate power. The BMUs are each configured to acquire a current signal of the battery cluster and a voltage signal of the cell connected to the BMU, calculate an impedance of the cell based on the current signal and the voltage signal, and transmit the impedance to the logical controller. The LC is configured to determine based on the impedance whether the cell malfunctions.

For details about the energy storage system, reference can be made to Figure 2. The multiple cells in the RACK are connected in series. The RACK is connected to the direct current side of the PCS through the direct current bus. A positive terminal of the RACK is connected to a positive conductor of the direct current bus, and a negative terminal of the RACK is connected to a negative conductor of the direct current bus.

Multiple BMU are arranged in the RACK. Each BMU is electrically connected to at least one cell. In other words, the BMU may be electrically connected to multiple cells, which is not limited herein. The BMU can acquire the voltage signal of a corresponding cell regardless of the number of cells connected to the BMU. A CMU is further arranged in the RACK.

In an embodiment, the CMU is configured to determine the current signal of the RACK and transmit the current signal to the BMU communicatively connected to the CMU.

The LC sends the inspection command on receipt of the cell inspection command. The PCS communicatively connected to the LC generates the alternating current voltage signal at the preset frequency based on the inspection command, to perform power regulation on the energy storage system. The CMU and the BMU communicatively connected to the LC measures parameters of the cells based on the inspection command. After acquiring the current detection signal of the RACK, the CMU performs fast Fourier transform on the current detection signal to determine the current signal of the RACK, and transmits the current signal to the BMU. After acquiring the voltage detection signal of the cell, the BMU performs the fast Fourier transform on the voltage detection signal to determine the current signal of the cell.

The BUM processes he current signal and the voltage signal of the cell at the varying frequency, to obtain the impedance of the cell at the varying frequency. For example, the preset frequency is set to 5Hz, and the current signal and the voltage signal at 5Hz are extracted to calculated the impedance at 5Hz. The BMU uploads the impedance of the cell to the LC. The LC analyzes the impedance of the cell, that is, determines whether the cell malfunctions. Alternatively, the BMU directly determines based on the impedance whether the cell malfunctions.

In an embodiment, the direct current side of the PCS is connected to one RACK only. The PCS is further configured to determine the current signal of the RACK and transmit the current signal to the BMU.

In case of only one RACK, the SCU in the PCS directly acquires the current detection signal, performs the fast Fourier transform on the acquired current detection signal, and then transmits the current signal to the BMU, for inspecting the cell.

In an embodiment, the LC is further configured to display alarm information if determined that the cell malfunctions.

The LC displays the alarm information when determined that there is a cell malfunctions, to protect other cells from being affected by the malfunctioning cell, thereby improving the reliability of the cells.

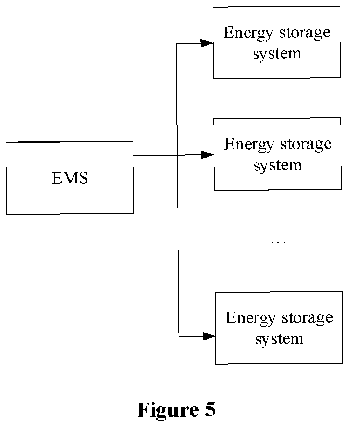

Based on the above energy storage system, an energy storage station is provided according to an embodiment of the present disclosure. Figure 5 is a schematic structural diagram illustrating the energy storage station according to the embodiment of the present disclosure. The energy storage station includes an EMS (energy management system) and at least one energy storage system according to any one of the above embodiments.

The EMS is configured to send the cell inspection command to the LC in the energy storage system to which the EMS is connected, for cell inspection by the energy storage system.

The energy storage station may include multiple energy storage systems. The EMS is communicatively connected to LCs in the multiple energy storage systems and sends the cell inspection command to the LCs. The LC sends the inspection command upon receipt of the cell inspection command, for cell inspection by the energy storage systems. The PCS, the CMU and the BMU according to the present disclosure cooperate to perform the cell inspection.

The energy storage system, the method for cell inspection by the energy storage system and the energy storage station according to the present disclosure have been introduced in detail. The technical solutions and embodiments of the present disclosure have been detailed by examples. The above description of the embodiments is used to only facilitate understanding of the method and the core idea of the present disclosure. In addition, those skilled in the art can make variations to the embodiments and the application range based on the idea of the present disclosure. In view of this, the content of the specification should not be understood as a limitation on the present disclosure.

It should be noted that the embodiments in this specification are described in a progressive way, each of the embodiments emphasizes the differences from other embodiments, and the same or similar parts among the embodiments may be referred to each other. Since the device disclosed in the embodiments corresponds to the method disclosed in the embodiments, the description for the device is simple, and reference may be made to the method in the embodiments for the relevant parts.

It should be further noted that, in the present disclosure, the relationship terminologies such as first, second or the like are only used herein to distinguish one entity or operation from another, rather than to necessitate or imply that an actual relationship or order exists between the entities or operations. Furthermore, terms of "include", "comprise" or any other variants are intended to be non-exclusive. Therefore, a process, method, article or device including a series of elements includes not only the listed elements but also elements inherent in the process, method, article or device. Unless expressively limited otherwise, the element defined by the statement "comprising (including) a..." does not exclude the case that other same elements may exist in the process, method, article or apparatus including the element.

Those skilled in the art can implement or practice the present disclosure based on the above description of the disclosed embodiments. Those skilled in the art can readily make various modifications to these embodiments. The general concept defined herein may be implemented in other embodiments without departing from the spirit and scope of the present disclosure. Therefore, the present disclosure should not be limited to the embodiments disclosed herein, but has the widest scope in accordance to the concept and the novel features disclosed herein.

## Claims

1. A method for cell inspection by an energy storage system, wherein the energy storage system comprises a power conversion system, PCS, and a battery cluster, the battery cluster comprises a plurality of cells, and the method comprises:
sending an inspection command to instruct the PCS to regulate power, upon receipt of a cell inspection command;
determining a current signal of the battery cluster; and
for each of the plurality of cells, determining a voltage signal of the cell, calculating an impedance of the cell based on the current signal and the voltage signal, and determining based on the impedance whether the cell malfunctions.

2. The method according to claim 1, wherein the sending the inspection command to instruct the PCS to regulate power comprises:
sending the inspection command; and
generating an alternating-current voltage signal at a preset frequency by the PCS and inputting the alternating-current voltage signal into the battery cluster.

3. The method according to claim 2, wherein the preset frequency ranges from 0Hz to 1kHz.

4. The method according to claim 2, wherein the generating the alternating-current voltage signal at the preset frequency by the PCS and inputting the alternating-current voltage signal into the battery cluster comprises:
generating the alternating-current voltage signal at the preset frequency by a direct current to direct current, DC/DC, conversion circuit in the PCS; and
inputting the alternating-current voltage signal into the battery cluster, wherein the battery cluster is connected to the DC/DC conversion circuit.

5. The method according to claim 1, wherein the determining the current signal of the battery cluster and the determining the voltage signal of the cell comprise:
acquiring a current detection signal of the battery cluster and acquiring a voltage detection signal of the cell; and
extracting the current signal from the current detection signal at a preset frequency and extracting the voltage signal from the voltage detection signal at the preset frequency.

6. The method according to claim 5, wherein the extracting the current signal from the current detection signal at the preset frequency and extracting the voltage signal from the voltage detection signal at the preset frequency comprises:
performing Fast Fourier Transform on the current detection signal and the voltage detection signal at the preset frequency.

7. The method according to any one of claims 1 to 6, wherein the determining based on the impedance whether the cell malfunctions comprises:
determining whether a difference between the impedance and preset internal resistance of the cell is less than a preset difference, or determining whether the impedance is within a preset reference range;
determining that the cell does not malfunction if determined that the difference is less than the preset difference or if determined that the impedance is within the preset reference range; and
determining that the cell malfunctions if determined that the difference is not less than the preset difference of if determined that the impedance is not within the preset reference range.

8. An energy storage system, comprising:
a logical controller;
a power conversion system, PSC; and
a battery cluster, wherein
the battery cluster comprises a plurality of cells;
a direct current side of the PCS is electrically connected to the battery cluster;
a cluster management unit, CMU, and a plurality of battery management units, BMU, are arranged in the battery cluster, and the BMU is electrically connected to at least one of the plurality of cells, and the CMU is communicatively connected to the plurality of BMUs;
the logical controller is communicatively connected to the CMU and the PCS; and
the logical controller, the PCS, the BMU and the CMU are configured to cooperate to perform the method according to any one of claims 1 to 8, wherein
the logical controller is configured to send an inspection command upon receipt of a cell inspection command;
the PCS is configured to regulate power;
the BMUs are each configured to acquire a current signal of the battery cluster and a voltage signal of the cell connected to the BMU, calculate an impedance of the cell based on the current signal and the voltage signal, and transmit the impedance to the logical controller; and
the logical controller is configured to determine based on the impedance whether the cell malfunctions.

9. The energy storage system according to claim 8, wherein
the CMU is configured to determine the current signal of the battery cluster and transmit the current signal to the BMUs.

10. The energy storage system according to claim 8, wherein
the number of the battery cluster is one, and the PCS is further configured to determine the current signal of the battery cluster and transmit the current signal to the BMUs.

11. The energy storage system according to any one of claims 8 to 10, wherein
the logical controller is further configured to display alarm information when determined that the cell malfunctions.

12. An energy storage station, comprising:
an energy management system, EMS; and
the energy storage system according to any one of claims 9 to 11, wherein the energy storage system is numbered at least one, and the EMS is configured to send a cell inspection command to the logical controller, for the energy storage system to perform cell inspection.
